# FASCICULE DE BREVET EUROPEEN

(11) **EP 0 623 828 B1**
(45) Date de publication et mention de la délivrance du brevet: **30.06.1999**
(21) Numéro de dépôt: 94400974.5
(22) Date de dépôt: 04.05.1994
(51) Int. Cl.: G01R 31/36

(54) **Système de reconnaissance et de gestion de générateurs électrochimiques**
System zur Identifikation und Steuerung eines elektrochemischen Generators
System for recognition and management of an electrochemical generator

(30) Priorité: 06.05.1993 FR 9305446
(43) Date de publication de la demande: 09.11.1994
(73) Titulaire: ALCATEL, 75008 Paris (FR)
(72) Inventeur: Andrieu, Xavier, F-91220 Bretigny sur Orge (FR)
(74) Mandataire: Laroche, Danièle

(56) Documents cités:
- EP-A- 0 448 755
- WO-A-92/22099
- GB-A- 2 219 151
- GB-A- 2 251 515
- US-A- 5 200 689

## Description

La présente invention concerne un système de reconnaissance et de gestion plus particulièrement destiné aux générateurs électrochimiques, généralement associés en batterie.

L'utilisation de générateurs électrochimiques dans les applications portables en particulier, pose le problème de connaître précisément la capacité disponible de ces générateurs ainsi que leur degré de vieillissement, qui se traduit par une diminution des performances au fur et à mesure de l'utilisation. En effet une mesure simple de tension ne permet pas d'apprécier correctement le taux de charge d'un générateur électrochimique.

Dans le cas d'une batterie d'accumulateurs utilisée dans une caméra vidéo portable, une solution proposée est le contrôle de l'état de charge effectué par une mesure coulométrique qui tient compte de l'autodécharge. Le dispositif associé à la batterie comporte un microcontrôleur 4 bits, et il est capable de détecter les fins de charge et de décharge pour se caler. Mais cette solution ne répond qu'en partie au problème posé et ce dispositif est par ailleurs d'un surcoût notable.

D'autre part, il est théoriquement possible de faire fonctionner des applications avec des générateurs électrochimiques de nature ou d'origine différentes. Dans la pratique cela pose de nombreux problèmes liés aux caractéristiques électriques différentes (tension, impédance interne,...) et se traduit souvent par une dégradation des performances du générateur électrochimique, et même parfois par un non fonctionnement. Pour un générateur électrochimique rechargeable les conséquences sont beaucoup plus graves s'il s'agit du chargeur, car un générateur électrochimique rechargeable qui est chargé de façon non appropriée peut être rapidement détérioré entraînant des risques importants concernant la sécurité (explosion, feu,...).

Afin d'éviter la charge de générateurs électrochimiques primaires, on place des détrompeurs mécaniques reconnus par le chargeur qui inhibent la charge. Des détrompeurs (résistances, diodes,...) destinés à l'identification du type de générateur afin d'y adapter les conditions de charge sont aussi mentionnés, par exemple dans les demandes de brevets britanniques GB-2 219 151 et GB-2 251 515 ou encore le brevet américain US-5,200,689. Mais cette technique ne peut être employée que pour une famille de produits provenant du même fabricant.

Le brevet JP-4 255 431 propose un chargeur capable de déterminer par une mesure de tension le type de générateur électrochimique rechargeable constituant la batterie pour appliquer ensuite le courant de charge qui convient. Cette méthode n'est applicable qu'à des batteries de générateurs électrochimiques rechargeables dont on connait le nombre d'éléments en série et qui demandent une charge lente. Il est impossible par une simple mesure de tension de déterminer si le générateur électrochimique rechargeable a été conçu pour supporter une charge en régime rapide.

La demande de brevet européen EP-0 448 755 propose de stocker les informations relatives au type du générateur dans une mémoire RAM non-volatile. Cette mémoire peut être modifiée ou effacée volontairement ou accidentellement ce qui n'autorise plus l'utilisation du générateur dans de bonnes conditions.

Par ailleurs la plupart des systèmes connus, comme par exemple celui décrit dans la demande de brevet WO-92 22099, comporte aussi un microprocesseur qui est un système complexe et coûteux et qui consomme beaucoup d'énergie.

La présente invention concerne en particulier un système permettant à une application d'identifier le type et les caractéristiques des générateurs électrochimiques qui lui sont reliés, sans risquer de perdre de ces informations pendant l'utilisation du générateur. Elle concerne en outre un système permettant de connaitre l'état de charge et le degré de vieillissement de ces générateurs, et de gérer les conditions de la décharge et de la recharge de générateurs électrochimiques rechargeables.

L'objet de la présente invention est un système de reconnaissance et de gestion d'une batterie comportant au moins un générateur électrochimique reliée à une application, caractérisé par le fait qu'il comprend une mémoire électronique placée dans ladite batterie comportant une première partie non effaçable contenant des informations permettant l'identification de ladite batterie, et une seconde partie qui peut être modifiée ou effacée contenant des informations sur le fonctionnement et l'état de ladite batterie, et un moyen de lecture de ladite mémoire et un moyen d'écriture dans ladite mémoire placés dans ladite application.

La mémoire électronique comporte une première partie exclusivement destinée à être lue qui contient des données intrinsèques au générateur, et une seconde partie destinée à être lue, modifiée et effacée pour suivre l'évolution des caractéristiques du générateur au cours de son vieillissement.

La première partie de la mémoire est plus particulièrement destinée à contenir des informations données par le fabricant qui permettent l'identification du générateur électrochimique (description, conditions de fonctionnement, etc...) . De préférence ces données sont introduites par le fabricant, dans ce cas la première partie de la mémoire peut être du type ROM (Read Only Memory). Mais des données peuvent être ajoutées par l'utilisateur, cette partie de la mémoire est alors de type EPROM (Electrically PROgrammable Memory). On entend par mémoire non effaçable que les données contenues dans ces mémoires ne peuvent être effacées volontairement ou accidentellement au cours de leur utilisation. Les informations contenues dans ces mémoires ne sont jamais modifiables.

Selon une forme d'exécution de la présente invention, la première partie de la mémoire contient sous forme codée au moins une donnée choisie parmi les données suivantes sur le générateur électrochimique:
- nature du couple électrochimique,
- tension nominale (V),
- capacité nominale (Ah),
- rechargeabilité ou non,
- seuil de tension maximum et minimum (sécurité),
- autodécharge (% par mois),
- référence du produit,
- nom du fabricant, etc...
mais également par exemple pour un générateur rechargeable:
- mode de charge, etc...

La seconde partie de la mémoire contient des informations sur le fonctionnement et l'état du générateur électrochimique. Ces données sont actualisées au fur et à mesure de la vie du générateur. Par l'intermédiaire du générateur cette seconde partie sert à transférer des données de façon bidirectionnelle entre les applications: chargeur, récepteur mobile, etc... Ici le terme "récepteur" désigne tout dispositif consommant le courant électrique fourni par le générateur.

Pour cette fonction la mémoire utilisée peut être du type RAM (Random Access Memory) ou EEPROM (Electrically Erasable PROgrammable Memory). L'accès en lecture ou en écriture à cette mémoire peut se faire à travers une liaison en série ou parallèle. Il est également possible d'associer à cette mémoire une horloge en temps réel dans le but de calculer l'autodécharge du générateur.

Selon encore une forme d'exécution de l'invention, la seconde partie de la mémoire contient sous forme codée au moins une donnée choisie parmi les données suivantes sur le générateur électrochimique:
- capacité instantanée (au moment de la mesure),
- capacité nominale actualisée compte-tenu du vieillissement du générateur,
- capacité déchargée cumulée, etc...
mais également à titre d'exemple pour un générateur rechargeable:
- nombre de cycles déjà effectués,
- date de la dernière charge, etc...

La condition minimum de fonctionnement d'un tel système est que les applications aient la capacité de communiquer avec la mémoire.

D'une part, le moyen de lecture permet à l'application de connaître les données contenues dans la mémoire du générateur électrochimique et d'adapter son fonctionnement. Par exemple, le chargeur utilisant l'invention est ainsi capable de charger avec efficacité et sécurité n'importe quel type de générateur électrochimique rechargeable qu'il a identifié. Le chargeur peut aussi refuser de charger un générateur électrochimique primaire ou un système électrochimique qu'il ne reconnait pas.

D'autre part, le moyen d'écriture permet à l'application de modifier les données contenues dans la seconde partie de la mémoire du générateur électrochimique, et d'y introduire des données supplémentaires. Par exemple, la charge terminée, le chargeur inscrit dans la seconde partie de la mémoire la quantité d'électricité introduite dans le générateur électrochimique rechargeable. Pendant la décharge, le récepteur déduit la quantité consommée. A la charge suivante, le chargeur sait par différence quelle quantité d'électricité il doit fournir au générateur.

Avec la seconde partie de la mémoire, il est également possible de suivre l'évolution des caractéristiques des générateurs électrochimiques comme la capacité nominale, l'autodécharge, etc... Pour des générateurs électrochimiques rechargeables par exemple, le chargeur peut effectuer des tests de capacité (décharges profondes) de façon périodique et automatique et en inscrire le résultat dans cette partie de la mémoire.

Le système de reconnaissance et de gestion selon l'invention est destiné à la liaison entre des générateurs électrochimiques et un récepteur mobile comme un téléphone portable, un outillage portatif, un jouet, une caméra vidéo portable, un véhicule électrique, etc... Par exemple dans la seconde partie de la mémoire, le récepteur lit la capacité disponible des générateurs électrochimiques, ensuite il y inscrit la quantité d'électricité consommée et la date de la décharge. Dans le cas des générateurs électrochimiques rechargeables, ces informations permettent à la charge suivante de se réinitialiser correctement.

Le système de reconnaissance et de gestion selon l'invention est également destiné à la liaison entre des générateurs électrochimiques rechargeables et un chargeur. Le chargeur est équipé d'un microprocesseur qui peut, grâce aux données lues dans la mémoire électronique des générateurs électrochimiques rechargeables, imposer les conditions de charges adéquates. La personalisation de la charge est obtenue par la lecture de la première partie de la mémoire et permet au chargeur d'accepter tout type de générateurs électrochimiques rechargeables. Les informations contenues dans la seconde partie de la mémoire sont modifiées par le chargeur pour y intégrer l'évolution des caractéristiques des générateurs électrochimiques rechargeables à la suite de la charge.

L'invention sera mieux comprise et d'autres avantages et particularités apparaîtront à la lecture des exemples de réalisation qui suivent, donnés à titre illustratif et non limitatif, accompagnés des dessins annexés parmi lesquels:
- la figure 1 représente un schéma simplifié d'une batterie de générateurs électrochimiques, dans laquelle est placée une mémoire électronique, reliée à une application,
- la figure 2 montre la configuration du système selon l'invention pour le cas d'une liaison entre une batterie de générateur électrochimiques rechargeables et un chargeur,
- la figure 3 est analogue à la figure 2 pour le cas d'une liaison entre une batterie de générateurs électrochimiques rechargeables et un radiotéléphone portable.

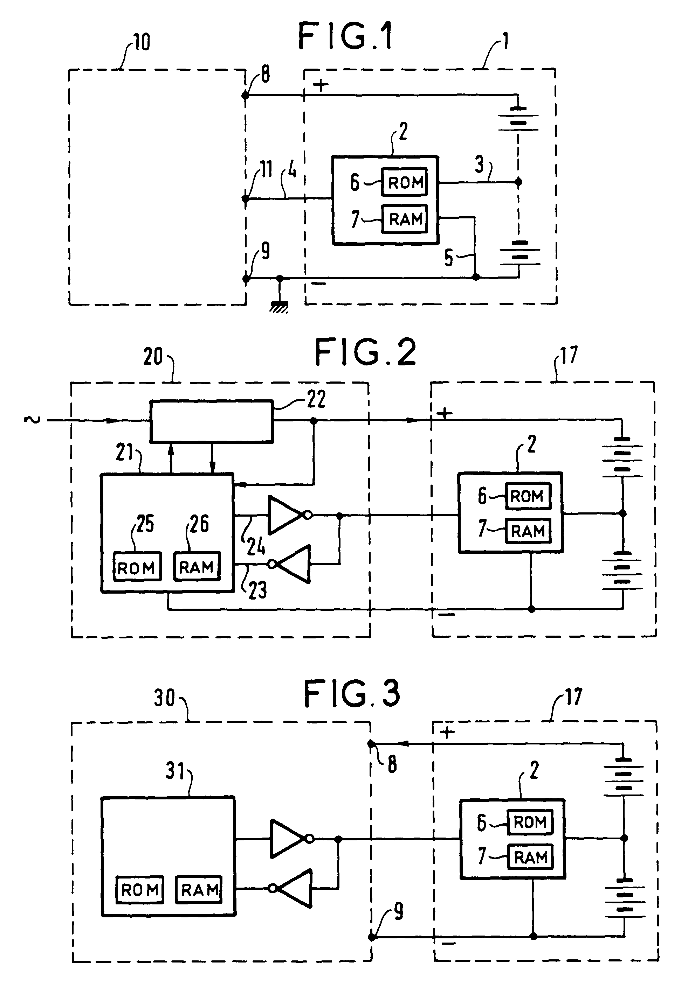

Une mémoire électronique 2 placée dans une batterie de générateurs électrochimiques 1, comme représenté sur la figure 1, peut être par exemple une mémoire du type "EconoRAM" de la société DALLAS SEMICONDUCTORS. Sa capacité est de 256 bits dont 32 bits en mémoire type ROM 6 et le reste (224 bits) en mémoire type RAM 7. Cette mémoire électronique 2 se présente sous la forme d'un boîtier plastique dont les trois fils émergeant ont les fonctions suivantes: un fil 3 d'alimentation positive, un fil 4 d'entrée/sortie de données en série, et un fil 5 relié à la masse. Les fils 3 et 5 sont connectés aux bornes 8 et 9 d'alimentation de l'application 10, et le fil 4 est relié à la borne 11. La consommation de la mémoire est de 1nA, sa tension d'alimentation est comprise entre 1,2V et 5,5V.

L'affectation des données dans la première partie de type ROM 6 de la mémoire 2 est la suivante:
- bits 1 à 3:: nature du couple électrochimique (8 possibilités)
0 nickel-cadmium
1 nickel-hydrure
2 nickel-zinc
3 plomb-acide
4 zinc-bioxyde de manganèse alcalin
5 à 7 générateurs au lithium
- bit 4:: rechargeabilité du générateur
0 non rechageable
1 rechargeable
- bits 5 à 8:: nombre de cellules dans la batterie (de 1 à 16)
- bits 9 à 16:: tension par élément (de 1V à 4V, par pas de 12mV),
ce qui représente 8 bits soit 255 combinaisons utilisables; la tension des éléments U en volts s'exprime alors par la formule: U=1+x(3/255) avec 0 ≤ x ≤ 255
- bits 17 à 24:: capacité de l'élément C, de même:
(de 50mAh à 12,8Ah, par pas de 50mAh) C(mAh)=50+x50 avec 0 ≤ x ≤ 255
- bits 25 et 26:: régime de charge admis
0 C/10
1 C/5
2 C
3 4C
- bits 27 et 28:: mode de charge
0 courant constant
1 tension constante
2 courant pulsé
3 autre mode
- bits 29 à 32:: code fabricant (16 possibilités)

D'autres données, comme les seuils de sécurité en tension, température, et temps, pourraient être également introduites en remplacement de certaines données qui précèdent, ou bien simplement ajoutées dans le cas où on utilise une mémoire ROM de capacité supérieure.

L'affectation des données dans la seconde partie de type RAM 7 de la mémoire est la suivante:
- bits 33 à 40:: nombre de charges complètes effectuées depuis la mise en service (de 0 à 2550) N=x10 avec 0 ≤ x ≤ 255
- bits 41 à 48:: capacité disponible à l'état chargé (elle varie avec le vieillissement) Q(mAh)=50+x50 avec 0 ≤ x ≤ 255
- bits 49 à 56:: capacité disponible (état de charge) D(mAh)=50+x50 avec 0 ≤ x ≤ 255
- bits 57 à 64:: capacité cumulée depuis la mise en service K(mAh)=50+x50 avec 0 ≤ x ≤ 255
- bits 65 à 71:: autodécharge (% par mois, de 1 à 127%)
- bits 72 à 85:: date de la dernière charge complète
bits 72 à 76: jour 1 à 31
bits 77 à 80: mois 1 à 12
bits 81 à 85: année 1993 à 2024
- bits 86 à 255:: libres pour d'autres applications

### EXEMPLE 1

Comme illustré par la figure 2, une mémoire 2, analogue à celle décrite précédemment, est placée dans une batterie de générateurs électrochimiques rechargeables, composée de 6 accumulateurs nickel-cadmium cylindriques spiralés de format AA (diamètre: 14,3mm , hauteur: 50,3mm ), référence VR de la société SAFT.

Dans ce cas le contenu de la première partie ROM 6 de la mémoire 2 est le suivant:

| | | |
|---|---|---|
| bits 1 à 3 | 000 | nickel-cadmium |
| bit 4 | 1 | rechargeable |
| bits 5 à 8 | 110 | 6 éléments |
| bits 9 à 16 | 00010001 | 1,2 Volts/accumulateur |
| bits 17 à 24 | 00001010 | 550mAh |
| bits 25 et 26 | 10 | courant de charge C |
| bits 27 et 28 | 00 | courant constant |
| bits 29 à 32 | 0000 | SAFT |

La seconde partie RAM 7 sera gérée au cours de l'utilisation par un chargeur et un récepteur.

La batterie 17 de générateurs électrochimiques rechargeables est reliée à un chargeur 20. Ce chargeur 20 est équipé d'un microprocesseur 21 qui utilise les informations contenues dans la mémoire 2 de la batterie 17 pour configurer le module 22 de régulation du courant. Cette configuration porte sur les données contenue dans la partie ROM 6 de la mémoire 2 comme:
- le courant de charge (C),
- la fixation des seuils de sécurité en tension, en température et en temps,
- le mode de charge: courant constant, etc...
et les données contenues dans la partie RAM 7 de la mémoire 2 comme:
- la capacité nominale actualisée,
- le nombre de cycles,
- la date de la dernière charge, etc...

La capacité instantanée est d'abord mesurée par méthode coulométrique, puis enregistrée cycliquement par le microprocesseur 21, et enfin transférée dans la seconde partie 7 de la mémoire 2 de la batterie 17.

Le microprocesseur 21 possède:
- un convertisseur de données analogiques en données digitales, permettant de lire et d'écrire les données analogiques nécessaires à la gestion de la charge (température, tension),
- un compteur de temps pour la gestion du temps de charge,
- une sécurité (chien de garde),
- une entrée réception 23 (RXD) et transmission 24 (TXD),
- une partie ROM 25 et une partie RAM 26 pour le traitement du logiciel,
- et le microprocesseur est piloté par une horloge à 11MHz.

Le microprocesseur peut être par exemple le circuit de référence ST6210 de la société SGS THOMSON qui comporte 8 bits.

### EXEMPLE 2

Une batterie 17 de générateurs électrochimiques rechargeables comportant une mémoire électronique 2, analogue à celle décrite dans l'exemple 1, est reliée aux bornes d'alimentation 8 et 9 d'un radiotéléphone portable 30 de type GSM (Global System for Mobile Communications) comme le montre la figure 3. Ce radiotéléphone 30 est équipé d'un microprocesseur 31 qui dialogue avec la mémoire 2 2 de la batterie 17 en y inscrivant la quantité d'électricité consommée et la date de la fin de la décharge. Le microprocesseur peut être du type 93C101 de la société PHILIPS.

Les informations inscrites par le microprocesseur dans la mémoire de la batterie permettent à la charge suivante au chargeur 20, analogue à celui décrit dans l'exemple 3, de calculer la quantité d'électricité nécessaire à la recharge complète de la batterie 17. Dans ce cas, le chargeur peut être intégré dans le radiotéléphone.

### EXEMPLE 3

Une mémoire, analogue à celle décrite précédemment, est placée dans une batterie de générateurs électrochimiques primaires composée de 5 piles cylindriques zinc-bioxyde de manganèse à électrolyte alcalin de format R14 (hauteur: 50mm, diamètre: 26mm), référence MN 1400 de la société DURACELL.

Dans ce cas le contenu de la première partie ROM de la mémoire est le suivant:

| | | |
|---|---|---|
| bits 1 à 3 | 010 | Zn-MnO₂ alcalin |
| bit 4 | 0 | primaire |
| bits 5 à 8 | 0101 | 5 éléments |
| bits 9 à 16 | 00101010 | 1,5 Volts/pile |
| bits 17 à 24 | 01101101 | 5500mAh |
| bits 25 et 26 | non utilisés | |
| bits 27 et 28 | non utilisés | |
| bits 29 à 32 | 0001 | DURACELL |

La seconde partie RAM 7 sera gérée au cours de l'utilisation par un récepteur.

La batterie de générateurs électrochimiques primaires est reliée aux bornes d'alimentation d'une caméra vidéo portable équipée d'un microprocesseur qui dialogue avec la mémoire de la batterie en y inscrivant la quantité d'électricité consommée et la date de la fin de la décharge. A la décharge suivante, les informations inscrites par le microprocesseur dans la mémoire de la batterie permettent à la caméra de connaître la quantité d'électricité encore disponible.

## Revendications

1. Système de reconnaissance et de gestion d'une batterie (17) comportant au moins un générateur électrochimique reliée à une application (30), ce système comprenant une mémoire électronique (2) placée dans ladite batterie (17) comportant une première partie (6) non effaçable et une seconde partie (7) qui peut être modifiée ou effacée contenant des informations sur le fonctionnement et l'état de ladite batterie (17), caractérisé par le fait que ladite première partie (6) non effaçable contient des informations permettant l'identification de ladite batterie (17), et par le fait que le système comprend un moyen de lecture (31) de ladite mémoire (2) et un moyen d'écriture (31) dans ladite mémoire (2) placés dans ladite application (30).

2. Système selon la revendication 1, caractérisé par le fait que ladite première partie de la mémoire contient des données introduites par le fabricant.

3. Système selon la revendication 2, caractérisé par le fait que ladite première partie de la mémoire contient des données introduites par l'utilisateur.

4. Système selon l'une des revendications précédentes, caractérisé par le fait que ladite première partie de la mémoire dudit générateur électrochimique contient au moins une donnée choisie parmi les données suivantes:
- nature du couple électrochimique,
- tension nominale,
- capacité nominale,
- rechargeabilité,
- seuil de tension maximum et minimum,
- autodécharge,
- référence du produit,
- nom du fabricant.

5. Système selon la revendication 1, caractérisé par le fait que ladite seconde partie de la mémoire dudit générateur électrochimique contient au moins une donnée choisie parmi les données suivantes:
- capacité instantanée,
- capacité nominale actualisée,
- capacité déchargée cumulée.

6. Système selon la revendication 1, caractérisé par le fait que ledit moyen de lecture permet à l'application de connaître les données contenues dans ladite mémoire.

7. Système selon la revendication 1, caractérisé par le fait que ledit moyen d'écriture permet à l'application de modifier les données contenues dans ladite seconde partie de la mémoire, et d'y introduire des données supplémentaires.

8. Système selon la revendication 1, où ladite application est choisie parmi les récepteurs mobiles consommant le courant fourni par lesdits générateurs électrochimiques.

9. Système selon la revendication 1, où ladite application est un chargeur et lesdits générateurs électrochimiques sont choisis parmi les générateurs électrochimiques rechargeables.

## Claims

1. A system for recognizing and managing a battery including at least one electrochemical cell connected to an application (30), the system comprising an electronic memory (2) placed in said battery (17) comprising:
a non-erasable first portion (6); and
a second portion (7) which may be modified or erased, and which contains information about the operation and the state of said battery (17);
the system being characterized by the fact that said non-erasable first portion (6) contains information enabling said battery (17) to be identified, and by the fact that it comprises read means for reading from said memory and write means for writing in said memory, said read means and said write means being placed in said application.

2. A system according to claim 1, characterized by the fact that said first portion of the memory contains data written by the manufacturer.

3. A system according to claim 2, characterized by the fact that said first portion of the memory contains data written by the user.

4. A system according to any preceding claim, characterized by the fact that said first portion of the memory of said electrochemical cell contains at least one item of data chosen from the following items of data:
type of the electrochemical couple;
nominal voltage;
nominal capacity;
rechargeability;
maximum and minimum voltage thresholds;
self-discharge;
reference of the product; and
name of the manufacturer.

5. A system according to claim 1, characterized by the fact that said second portion of the memory of said electrochemical cell contains at least one item of data chosen from the following items of data:
instantaneous capacity;
updated nominal capacity; and
cumulative discharged capacity.

6. A system according to claim 1, characterized by the fact that said read means enable the application to become informed of the data contained in said memory.

7. A system according to claim 1, characterized by the fact that said write means enable the application to modify the data contained in said second portion of the memory, and to write additional data therein.

8. A system according to claim 1, where said application is chosen from mobile loads that consume current supplied by said electrochemical cells.

9. A system according to claim 1, where said application is a charger and said electrochemical cells are chosen from rechargeable electrochemical cells.

## Patentansprüche

1. System zur Identifikation und Steuerung einer Batterie (17), das wenigstens einen, mit einer Anwendung (30) verbundenen, elektrochemischen Generator umfaßt, wobei dieses System mit einem, in die genannte Batterie (17) eingesetzten, elektronischen Speicher (2) ausgestattet ist, der einen nicht löschbaren ersten Teil (6) und einen zweiten Teil (7), der modifiziert oder gelöscht werden kann und Informationen über den Betrieb und den Zustand der genannten Batterie (17) enthält, aufweist,
**dadurch gekennzeichnet, daß** der genannte nicht löschbare erste Teil (6) Informationen enthält, die die Identifikation der genannten Batterie (17) ermöglichen, und daß das System eine Vorrichtung zum Lesen (31) aus dem genannten Speicher (2) und eine Vorrichtung zum Schreiben (31) in den genannten Speicher (2), die in die genannte Anwendung (30) eingesetzt sind, aufweist.

2. System nach Anspruch 1,
**dadurch gekennzeichnet, daß** der genannte erste Teil des Speichers durch den Hersteller eingegebene Daten enthält.

3. System nach Anspruch 2,
**dadurch gekennzeichnet, daß** der genannte erste Teil des Speichers durch den Verwender eingegebene Daten enthält.

4. System nach einem der vorhergehenden Ansprüche,
**dadurch gekennzeichnet, daß** der genannte erste Teil des Speichers des genannten elektrochemischen Generators wenigtens eine Angabe enthält, die aus den folgenden Daten gewählt ist:
- Art des elektrochemischen Paars,
- Nennspannung,
- Nennkapazität,
- Aufladbarkeit
- maximale und minimale Spannungsgrenze,
- Selbstentladung,
- Produktreferenz,
- Name des Herstellers.

5. System nach Anspruch 1,
**dadurch gekennzeichnet, daß** der genannte zweite Teil des Speichers des genannten elektrochemischen Generators wenigstens eine Angabe enthält, die aus den folgenden Daten gewählt ist:
- Momentkapazität,
- aktualisierte Nennkapazität,
- kumulierte entladene Kapazität.

6. System nach Anspruch 1,
**dadurch gekennzeichnet, daß** die genannte Vorrichtung zum Lesen es ermöglicht, daß die Anwendung, die im genannten Speicher enthaltenen Daten erkennt.

7. System nach Anspruch 1,
**dadurch gekennzeichnet, daß** die genannte Vorrichtung zum Schreiben es der Anwendung ermöglicht, die im genannten zweiten Teil des Speichers enthaltenen Daten zu modifizieren, und dort zusätzliche Daten einzugeben.

8. System nach Anspruch 1, wobei die genannte Anwendung aus den mobilen Aufnehmern, die den von den genannten elektrochemischen Generatoren gelieferten Strom verbrauchen, gewählt ist.

9. System nach Anspruch 1, wobei die genannte Anwendung eine Ladevorrichtung ist und die genannten elektrochemischen Generatoren unter den wiederaufladbaren elektrochemischen Generatoren gewählt sind.
